(19) Europäisches Patentamt European Patent Office Office européen des brevets

(11) **EP 4 417 896 A1**

(12) **EUROPEAN PATENT APPLICATION**
published in accordance with Art. 153(4) EPC

(43) Date of publication:
21.08.2024 Bulletin 2024/34

(21) Application number: 22880363.1

(22) Date of filing: 13.10.2022

(51) International Patent Classification (IPC):
*F24S 70/60* (2018.01) *F24S 10/00* (2018.01)
*F24S 23/30* (2018.01)

(52) Cooperative Patent Classification (CPC):
**F24S 10/00; F24S 23/30; F24S 23/70; F24S 70/10;**
**F24S 70/60; F24S 80/60**

(86) International application number:
PCT/CN2022/125029

(87) International publication number:
WO 2023/061427 (20.04.2023 Gazette 2023/16)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: 14.10.2021 CN 202111197764

(71) Applicant: **Winner Technology Co., Ltd.**
**Toufen Miaoli, Taiwan 351 (TW)**

(72) Inventor: **LIN, Chih-shen**
**Toufen City, Miaoli County, Taiwan 351 (TW)**

(74) Representative: **Straus, Alexander**
**2K Patent- und Rechtsanwälte - München**
**Keltenring 9**
**82041 Oberhaching (DE)**

(54) **SOLAR HEAT COLLECTION DEVICE**

(57) A solar energy collector comprises a body, wherein the body has a geometric shape with a hollow interior. The body has multiple openings arranged at intervals around a Y-axis to allow a light ray to enter, and the openings are distributed along a Z-axis at different height positions. This arrangement reduces light exposure and disperses most of the thermal energy to be absorbed within the body. The light ray enters the interior of the body after being concentrated and reflected by a light path mechanism. Once inside the collector body, the light ray will be continuously reflected until it is absorbed, maximizing the utilization rate of the light ray.

Fig 4

## Description

This application claims priority to Chinese Patent Application No. CN202111197764.0, entitled "Solar Energy Collector", filed with the China National Intellectual Property Administration on October 14, 2021, the entire contents of which are incorporated herein by reference.

## FIELD OF INVENTION

The present invention relates to a concentrated solar energy collector, particularly a solar energy collector capable of increasing the utilization rate of sunlight.

## BACKGROUND OF THE INVENTION

Concentrated Solar Power (CSP) has been in development for decades, yet widespread adoption remains elusive. One contributing factor is the relatively low utilization rate of solar energy collection and conversion. In addition to dispersion and losses between the reflector and receiver, energy is lost through reflection of the light energy received during conversion or saturation, while the receiver may also suffer significant convective heat loss when exposed to the atmosphere. Additionally, the open concentrated light path can also pose a hazard to birds and the environment due to high-temperature light emissions, making it difficult to gain market acceptance.

## SUMMARY OF THE INVENTION

Based on the above shortcomings, the purpose of the present invention is to provide a solar energy collector, in particular the solar energy collector capable of increasing the utilization rate of sunlight.

In order to achieve the above purpose, the solar energy collector provided by the present invention comprises a body, wherein the body has a geometric shape and the interior of the body is hollow. The body has at least one opening for allowing a light ray to enter the body, a thermal conduction trough disposed on the body, and a thermal conduction device disposed in the thermal conduction trough.

Wherein, a thermoelectric module is disposed between the thermal conduction trough and the thermal conduction device, and the thermal conduction trough is filled with a heat transfer medium to ensure that it is capable of high-temperature conduction and to increase the heat transfer contact area.

Wherein, the body has multiple openings, and the multiple openings are arranged at intervals around a Y-axis, and the multiple openings are distributed along a Z-axis and are respectively located at different height positions, and multiple thermal insulation sleeves are disposed in the multiple openings.

Wherein, the light ray enters the interior of the body after being concentrated and reflected by a light path mechanism, wherein the body and the light path mechanism are disposed in a vacuum housing and spaced apart from each other.

Preferably, the light path mechanism is a light guide mirror assembly comprising at least one condensing lens, at least one reflector, and/or at least one focusing lens, and/or at least one focal length conversion lens.

Preferably, the light path mechanism is a light guide tube assembly composed of multiple light guide tubes, wherein one end of each light guide tube is disposed at the multiple openings of the body, and the other end is spaced apart from the condensing lens.

Preferably, the inner surface of the body is spherical, hexagonal, or a symmetrical geometric shape.

Preferably, at least one absorbing layer is disposed on the inner surface of the body, and at least one thermal insulation layer is disposed on the outer surface of the body.

Preferably, the material of the at least one absorbing layer is selected from a group consisting of graphite, tungsten carbide, carbon nanotubes, nanomaterials, or any combination of one or more thereof.

Preferably, the material of the at least one thermal insulation layer is selected from a group consisting of zirconia, diatomite, ceramic wool, porous composites, nanomaterials, or any combination of one or more thereof.

Preferably, the material of the body is selected from a group consisting of rhenium-carbon-nitride, graphite, tungsten carbide, silicon carbide, aluminum nitride, carbide composites, alloyed steels, or any combination of one or more thereof.

## BRIEF DESCRIPTION OF THE DRAWINGS

FIG. 1 is a schematic view of a first embodiment of the body of the solar energy collector.

FIG. 2 is a light path diagram of light rays entering the body.

FIG. 3 is a schematic view of a second embodiment of the body of the solar energy collector.

FIG. 4 is a schematic view of the second embodiment of the present invention.

FIG. 5 is a schematic view of a third embodiment of the present invention.

FIG. 6 is a cross-sectional view along A-A of the third embodiment of the present invention.

FIG. 7 is a schematic view of a fourth embodiment of the present invention.

FIG. 8 is a light path diagram of the fourth embodiment of the present invention.

FIG. 9 is a light path diagram of a fifth embodiment of the present invention.

FIG. 10 is a schematic view of a sixth embodiment of the present invention.

FIG. 11 is a light path diagram of the sixth embodiment of the present invention.

**Reference Numerals**

20: Body
20a: Absorbing layer
20b: Thermal insulation layer
21: Thermal insulation sleeve
30: Thermal conduction trough
31: Thermal conduction device
40: Thermoelectric module
41: Heat transfer medium
61: Focusing lens
62: Reflector
63: Focal length conversion lens
64: Condensing lens
70: Light guide tube
70a: Reflecting layer
70b: Insulating layer
L: Light ray
F: Focus

**DETAILED DESCRIPTION OF THE PREFERRED EMBODIMENTS**

In order to clearly explain the specific embodiments, structures, and effects achieved by the present invention, the following description is made with reference to the accompanying drawings:

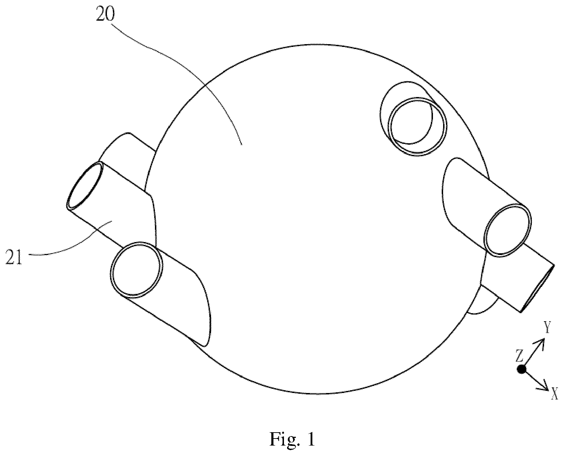

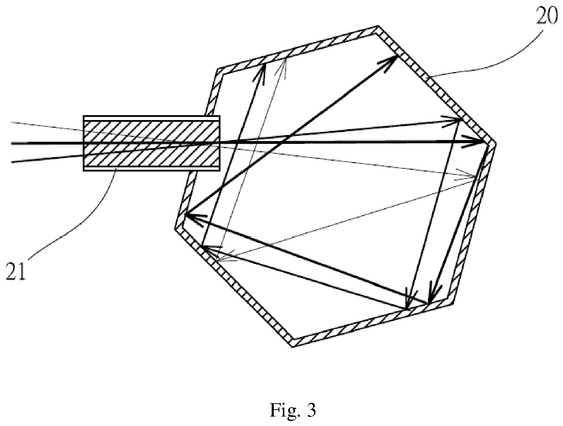

Referring to FIGS. 1 to 3, a solar energy collector is shown comprising a body 20. The body 20 has a geometric shape, and the interior of the body 20 is hollow. The body 20 has at least one opening for allowing a light ray to enter the body 20. In this embodiment, the body 20 is a hollow spherical shape, that is, the inner surface of the body is spherical. In other embodiments, the body 20 may be, but is not limited to, a hollow hexagonal chamber (see FIG. 3) or other symmetrical geometric shapes, that is, the inner surface of the body is hexagonal or other symmetrical geometric shapes.

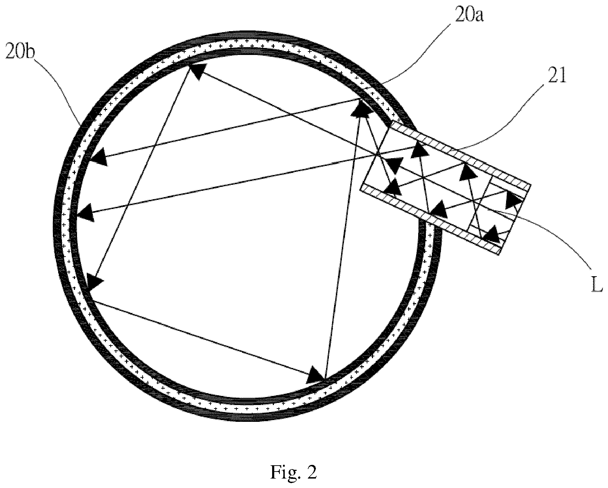

Referring to FIG. 1, the body 20 has multiple openings, and the multiple openings are arranged at intervals around a Y-axis, and the multiple openings are distributed along a Z-axis and are respectively located at different height positions, i.e., the multiple openings form a spiral shape when lined up along the outer surface of the body 20. In this way, light exposure can be reduced and most of the thermal energy can be dispersedly absorbed within the body 20. In the embodiment of the present invention, a light path mechanism and the body 20 are spaced apart and disposed within a vacuum housing (not shown). The light ray L is concentrated and reflected by the light path mechanism before entering the interior of the body 20, thereby reducing the loss of the light ray L. Refer to FIGS. 2 and 3 for the light path diagrams of the light ray within the body 20. After the light ray L enters the interior of the solar energy collector body 20, it will be continuously reflected within the body 20 until it is absorbed, thereby maximizing the utilization rate of the light ray L.

Furthermore, in the embodiment of the present invention, multiple thermal insulation sleeves 21 are disposed in the multiple openings. The thermal insulation sleeves 21 have characteristics of low thermal conductivity, low radiation loss, and high-temperature resistance. The material of the thermal insulation sleeves 21 may be, but is not limited to, zirconia, ceramic wool, or nanomaterials. The thermal insulation sleeves 21 are used to prevent the tubes connected to the body 20 from being damaged by overheating and to reduce the leakage of reflected light.

The body 20 has characteristics of high thermal conductivity and high-temperature resistance. The material of the body 20 is selected from a group consisting of rhenium-carbon-nitride, graphite, tungsten carbide, silicon carbide, aluminum nitride, alloyed steels, or any combination of one or more thereof.

At least one absorbing layer 20a is disposed on the inner surface of the body 20. The absorbing layer 20a has photothermal conversion and high absorption characteristics. The absorbing layer 20a can absorb at least 95% of thermal energy, and the absorbing layer 20a can absorb the energy of the light ray L and convert it into thermal energy. The material of the absorbing layer 20a may be, but is not limited to, graphite, tungsten carbide, carbon nanotubes, nanomaterials, or a combination of various light-absorbing substances. At least one thermal insulation layer 20b is disposed on the outer surface of the body 20. The thermal insulation layer 20b has low thermal conductivity, low radiation loss, and high-temperature resistance characteristics. The thermal insulation layer 20b reduces the heat loss from the interior of the body 20. The material of the thermal insulation layer 20b may be, but is not limited to, zirconia, diatomite, ceramic wool, porous composites, nanomaterials, an air insulating layer, or a vacuum insulating layer. Optionally, the thermal insulation layer 20b can be in direct contact with the absorbing layer 20a, or there may be an intermediate layer between the thermal insulation layer 20b and the absorbing layer 20a.

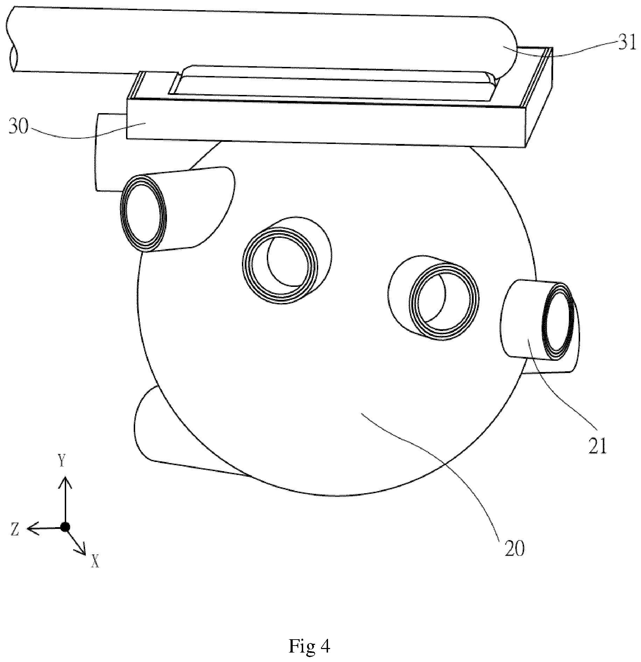

Referring to FIG. 4, which illustrates a second embodiment of the present invention. In the second embodiment, a thermal conduction trough 30 is disposed on the top of the body 20, and a thermal conduction device 31 is disposed in the thermal conduction trough 30 to conduct the thermal energy generated inside the body 20 to the outside.

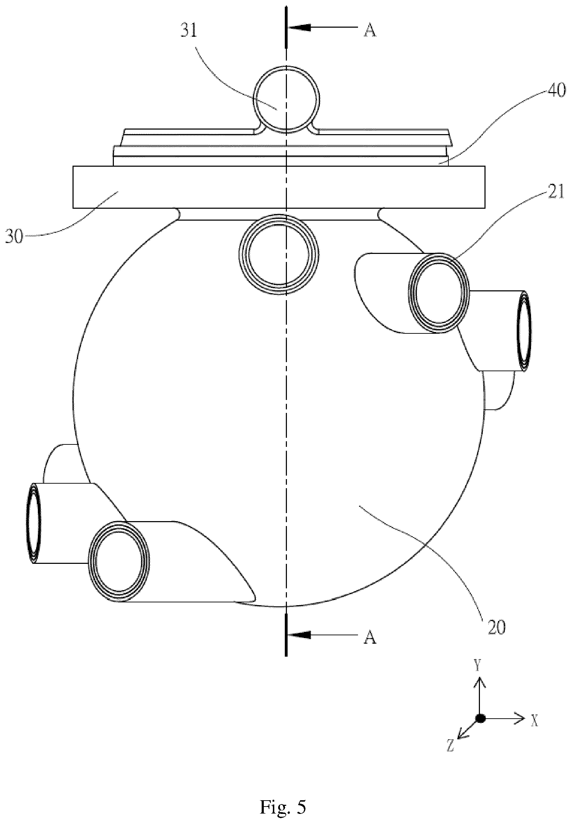

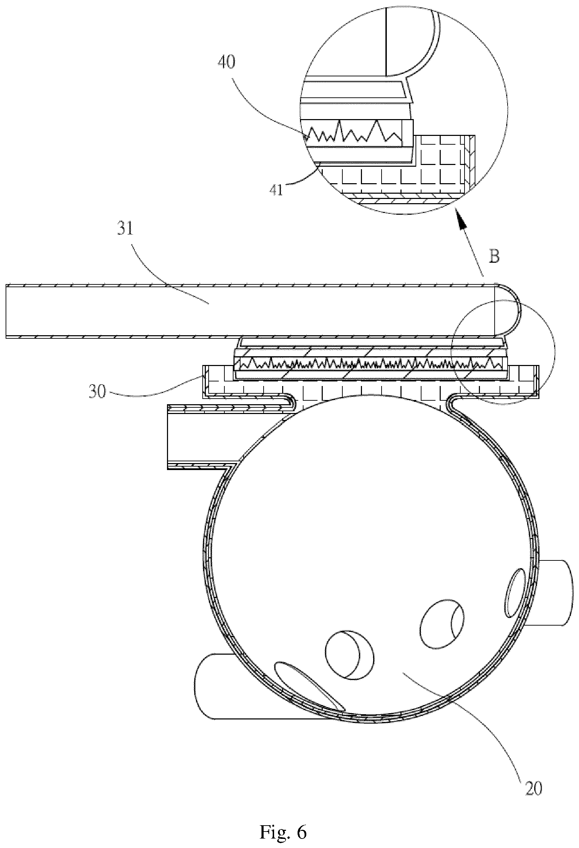

Referring to FIGS. 5 and 6, which illustrate a third embodiment of the present invention. In the third embodiment, a thermoelectric module 40 is further disposed between the thermal conduction trough 30 and the thermal conduction device 31. The thermal conduction trough 30 is filled with a heat transfer medium 41, which may be, but is not limited to, a high-temperature phase change liquid metal. The heat transfer medium 41 is filled to export the thermal energy generated by the body 20, to ensure that it is capable of high-temperature conduction, and to increase the heat transfer contact area.

The positive and negative electrodes of the thermoelectric module 40 are high-temperature metal carbides such as tungsten carbide. A high-temperature insulation layer (not shown), which is an insulating hollow ceramic such as zirconia or quartz glass, is provided between the positive and negative electrodes, and a diamond field electron emitter (not shown) is formed on the high-temperature metal carbide at the heated end. The edges where the positive and negative electrodes are joined to the high-temperature insulation layer have an annular notch (not shown) to facilitate high-energy pulsed laser welding. By using the above high-temperature materials and packaging methods, the thermoelectric module 40 can operate at a temperature of about 2000°C, thereby improving power generation efficiency.

The thermal conduction trough 30 at the top of the body 20 is connected to the heated end of the thermoelectric module 40 or the thermal conduction device 31 by filling the heat transfer medium 41. When the thermoelectric module 40 is provided, the thermal conduction device 31 is connected to the cold end of the thermoelectric module 40. When the light ray L enters the body, it is continuously reflected and absorbed within the body 20 to generate thermal energy. The thermal energy is transmitted to the thermoelectric module 40 or the thermal conduction device 31 through the heat transfer medium 41, and the thermal conduction device 31 conducts the thermal energy to external facilities for application. In this way, not only can the thermoelectric module 40 be effectively used for power generation, but the waste heat energy of the thermoelectric module 40 can also be conducted to external facilities for application, thereby improving energy efficiency.

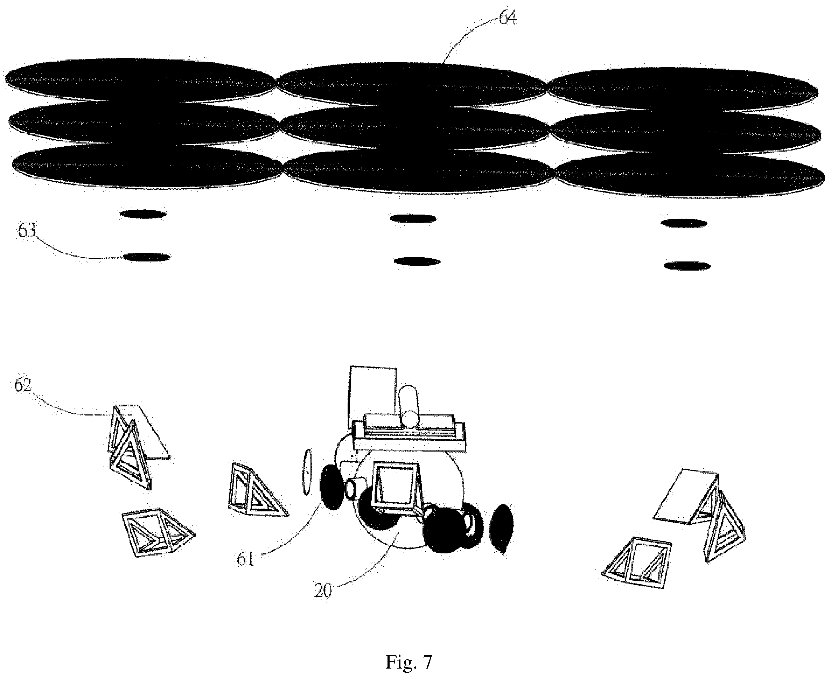

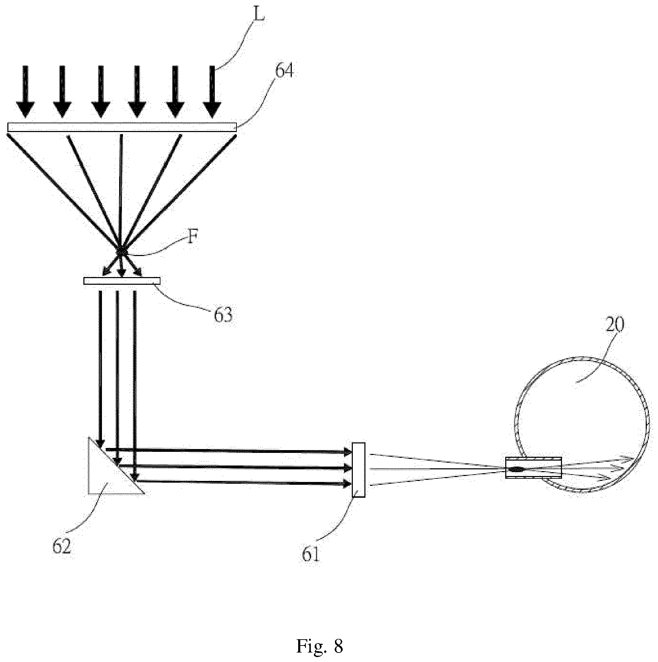

Referring to FIGS. 7 and 8, which illustrate a fourth embodiment of the present invention. In the fourth embodiment, the light path mechanism is a light guide mirror assembly comprising, in sequence, at least one condensing lens 64, at least one focal length conversion lens 63, at least one reflector 62, and at least one focusing lens 61. Wherein the focal length conversion lens 63 is relatively closer to the condensing lens 64, the focusing lens 61 is relatively closer to the body 20, and the reflector 62 is disposed between the focal length conversion lens 63 and the focusing lens 61. In the embodiment of the present invention, the condensing lens 64 is a Fresnel lens. In other embodiments, the condensing lens 64 is not limited to the Fresnel lens.

Referring to FIG. 8, which illustrates the light path diagram of the light ray L entering the solar energy collector through the lenses. When the light ray L is focused through the condensing lens 64 at the focus F, the light ray L is reflected by the focal length conversion lens 63 to the reflector 62, then reflected by the reflector 62 to the focusing lens 61, and allows the light ray L to enter the body 20 through the focusing lens 61, thereby allowing the light ray L to be continuously reflected and absorbed within the solar energy collector to further generate thermal energy.

The solar light ray L can receive 180 watts of solar energy per square meter on average, and the light absorption rate of the aforementioned lenses is less than 5%. Therefore, based on the law of conservation of energy, the solar light ray L, after being reflected and transmitted by four lenses to the body 20 with an absorption rate of more than 95%, can be calculated as:

$$180 \times 0.95 \times 0.95 \times 0.95 \times 0.95 \times 0.95 = 139.28\text{W}$$

The temperature difference can be calculated based on the specific heat capacity of the body 20, assuming that the ambient temperature is 30°C, the mass of the body 20 is 1kg, the specific heat of tungsten carbide is 390 $(J/kg°C)$, and the concentrated light area is 100 $m^2$:

$$390 = (139.28 \times 60 \times 100) / 1 \times (t2 - 30)$$

$$t2 = (835680 + 11700) / 390 = 2172.77°C$$

Thus, the body 20 can generate thermal energy of 2172.77°C, which effectively increases the utilization rate of thermal energy.

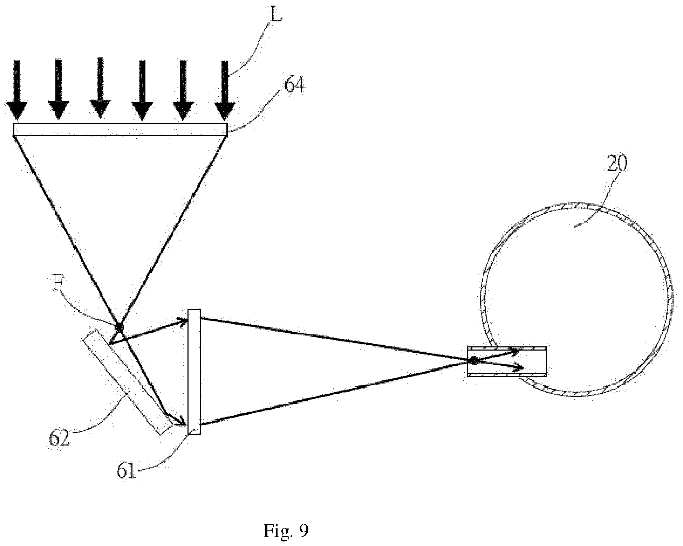

Referring to FIG. 9, which illustrates a fifth embodiment of the present invention. In the fifth embodiment, the light guide mirror assembly comprises the at least one condensing lens 64, the at least one reflector 62, and the at least one focusing lens 61. The at least one reflector 62 and the at least one focusing lens 61 are provided between each condensing lens 64 and the body 20. The reflector 62 is relatively closer to the condensing lens 64 and the focusing lens 61 is relatively closer to the body 20, forming the reflector 62 between the condensing lens 64 and the focusing lens 61. The light ray L focused by the condensing lens 64 is first reflected by the reflector 62 to the focusing lens 61, which focuses and reduces the area of the light ray L before entering the body 20 to generate thermal energy. In other embodiments, the light guide mirror assembly may also comprise the at least one condensing lens 64, the at least one reflector 62, and the at least one focal length conversion lens 63, where the light ray L is reflected by the reflector 62 directly into the body 20, thereby achieving the same effect as described above.

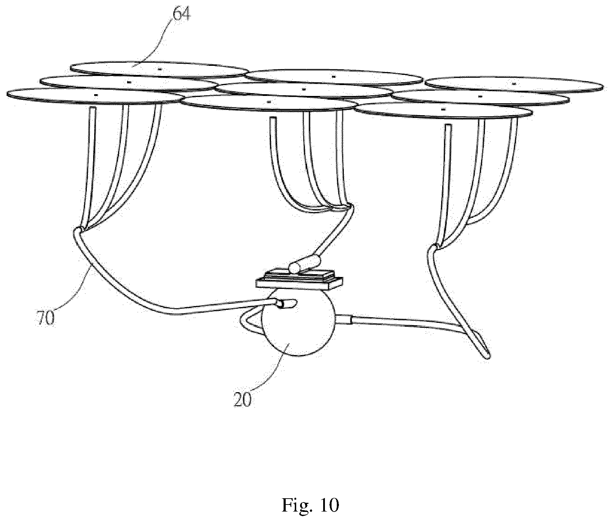

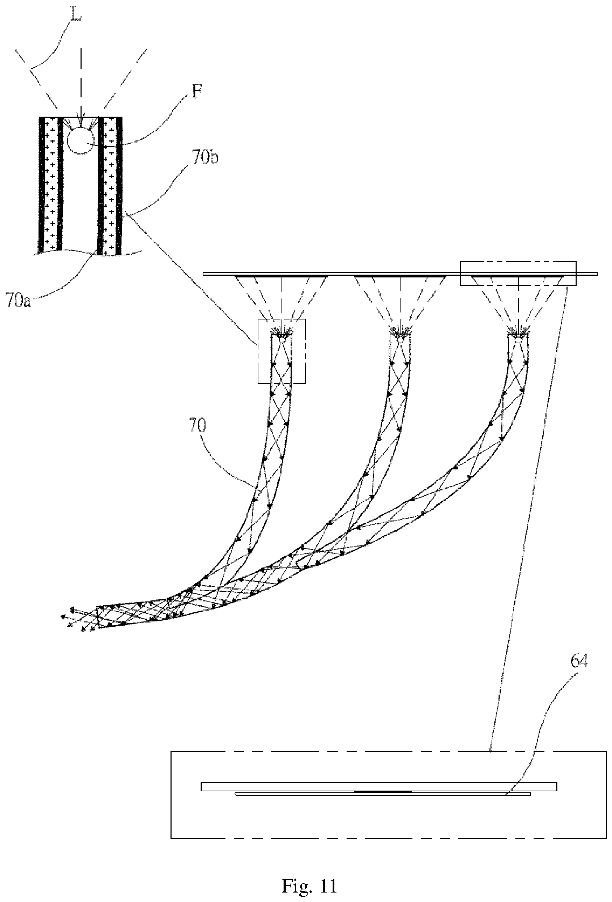

Referring to FIGS. 10 and 11, which illustrate a sixth embodiment of the present invention. In the sixth embodiment, the light path mechanism is a light guide tube assembly. The light guide tube assembly includes multiple spaced light guide tubes 70, and each light guide tube 70 is composed of multiple spaced tubes. One end of the light guide tube assembly is disposed at the thermal insulation sleeve 21, and the other end is spaced apart from the condensing lens 64 by a distance approximately equal to the focal length of the condensing lens 64, thereby reducing the inner diameter of the light guide tube. In the embodiment of the present invention, the condensing lens 64 is the Fresnel lens. In other embodiments, the condensing lens 64 is not limited to the Fresnel lens.

In the sixth embodiment, the number of condensing lenses 64 is the same as the number of tubes of the light guide tube 70. Each light guide tube 70 has three tubes connected in a Y-shape to collect the light rays into the light guide tube 70 connected to the body 20, i.e., each light guide tube 70 has three tubes spaced apart, and each tube corresponds to one condensing lens 64 at the same spaced apart distance, thereby reducing the number of light inlets and reducing the volume of the body 20. In other embodiments, the number of condensing lenses 64 may be reduced to one.

In the sixth embodiment, a reflecting layer 70a is disposed on the inner surface of the light guide tube 70, and the reflecting layer 70a receives the light ray reflected from the condensing lens 64. An insulating layer 70b is disposed on the outer surface of the light guide tube 70, and the insulating layer 70b has low thermal conductivity, low radiation loss, and high-temperature resistance characteristics. The material of the insulating layer 70b may be, but is not limited to, zirconia, diatomite, ceramic wool, porous composites, nanomaterials, an air insulating layer, or a vacuum insulating layer.

The light ray L is focused and refracted by the condensing lens 64 into the light guide tube 70, and is reflected multiple times by the reflecting layer 70a before entering the interior of the body 20. At this time, the light ray L contacts the absorbing layer 20a of the body 20, and in addition to being continuously reflected within the body 20, the absorbing layer 20a also converts the light ray L into thermal energy.

The present invention utilizes the light ray L entering the interior of the body 20 of the solar energy collector, where the light ray L is continuously reflected and absorbed within the body 20 until it is converted into thermal energy, thereby maximizing the utilization rate of the light ray L. Meanwhile, by being installed in the vacuum housing, the convective heat loss of air can be reduced, thereby enabling high-temperature thermal energy to be provided for power generation or other applications.

**Claims**

1. A solar energy collector, comprising:

   a body(20), being a geometric shape, and the interior of the body (20) being hollow, having at least one opening for allowing a light ray (L) to enter the body (20);

a thermal conduction trough (30), disposed on the body (20); and
a thermal conduction device (31), disposed in the thermal conduction trough (30).

2. The solar energy collector according to Claim 1, further comprising a thermoelectric module (40) disposed between the thermal conduction trough (30) and the thermal conduction device (31).

3. The solar energy collector according to Claim 1, wherein the thermal conduction trough (30) is filled with a heat transfer medium (41).

4. The solar energy collector according to Claim 1, wherein the body (20) has multiple openings, and the multiple openings are arranged at intervals around a Y-axis, and the multiple openings are distributed along a Z-axis and are respectively located at different height positions.

5. The solar energy collector according to Claim 4, further comprising multiple thermal insulation sleeves (21) disposed in the multiple openings.

6. The solar energy collector according to Claim 1, wherein the light ray (L) enters the interior of the body (20) after being concentrated and reflected by a light path mechanism.

7. The solar energy collector according to Claim 6, wherein the body (20) and the light path mechanism are disposed within a vacuum housing and spaced apart from each other.

8. The solar energy collector according to Claim 6, wherein the light path mechanism is a light guide mirror assembly comprising at least one condensing lens (64) or at least one reflector (62).

9. The solar energy collector according to Claim 8, wherein the light guide mirror assembly further comprises at least one focusing lens (61).

10. The solar energy collector according to Claim 8, wherein the light guide mirror assembly further comprises at least one focal length conversion lens (63).

11. The solar energy collector according to Claim 6, wherein the light path mechanism is a light guide tube assembly composed of multiple light guide tubes (70), wherein one end of each light guide tube (70) is disposed at the multiple openings of the body (20), and the other end is spaced apart from a condensing lens by a distance.

12. The solar energy collector according to Claim 1, wherein the inner surface of the body (20) is spherical, hexagonal, or a symmetrical geometric shape.

13. The solar energy collector according to Claim 1, further comprising at least one absorbing layer (20a) disposed on the inner surface of the body (20), and at least one thermal insulation layer (20b) disposed on the outer surface of the body (20).

14. The solar energy collector according to Claim 13, wherein the material of the at least one absorbing layer (20a) is selected from a group consisting of graphite, tungsten carbide, carbon nanotubes, nanomaterials, or any combination of one or more thereof.

15. The solar energy collector according to Claim 13, wherein the material of the at least one thermal insulation layer (20b) is selected from a group consisting of zirconia, diatomite, ceramic wool, porous composites, nanomaterials, or any combination of one or more thereof.

16. The solar energy collector according to Claim 1, wherein the material of the body (20) is selected from a group consisting of rhenium-carbon-nitride, graphite, tungsten carbide, silicon carbide, aluminum nitride, carbide composites, alloyed steels, or any combination of one or more thereof.

Fig. 1

Fig. 2

Fig. 3

Fig 4

Fig. 5

Fig. 6

Fig. 7

Fig. 8

Fig. 9

Fig. 10

Fig. 11

## INTERNATIONAL SEARCH REPORT

| International application No. |
|---|
| **PCT/CN2022/125029** |

| A. | CLASSIFICATION OF SUBJECT MATTER |
|---|---|

F24S 70/60(2018.01)i; F24S 10/00(2018.01)i; F24S 23/30(2018.01)i

According to International Patent Classification (IPC) or to both national classification and IPC

| B. | FIELDS SEARCHED |
|---|---|

Minimum documentation searched (classification system followed by classification symbols)

F24S; F24J

Documentation searched other than minimum documentation to the extent that such documents are included in the fields searched

Electronic data base consulted during the international search (name of data base and, where practicable, search terms used)

CNTXT, WPABS, DWPI, ENTXT, Patentics, 中国期刊网全文数据库, CJFD: 林郅燊, 营嘉科技, 太阳能, 光能, 吸收器, 接收器, 集中器, 集光器, 中空, 腔, 壳, 多, 复数, 若干, 孔, 开口, 反射, 传热, 导热, 热传递, 热交换, 散热, 热电芯片, 热电模块, solar, collect+, absorb+, receiv+, cavity, hollow, opening+, hole?, reflect+, thermoelectric+

| C. | DOCUMENTS CONSIDERED TO BE RELEVANT |
|---|---|

| Category* | Citation of document, with indication, where appropriate, of the relevant passages | Relevant to claim No. |
|---|---|---|
| X | RU 39688 U1 (ВОХМИН Петр, et al.) 10 August 2004 (2004-08-10) description, specific embodiments, and figures 1-3 | 1-3, 6-16 |
| Y | RU 39688 U1 (ВОХМИН Петр, et al.) 10 August 2004 (2004-08-10) description, specific embodiments, and figures 1-3 | 4-5 |
| Y | CN 102959344 A (PENWORTH PTY LTD.) 06 March 2013 (2013-03-06) description, paragraph 0070, and figure 5 | 4-5 |
| X | TW 201616071 A () 01 May 2016 (2016-05-01) description, specific embodiments, and figures 1-3 | 1, 3, 6-16 |
| Y | TW 201616071 A () 01 May 2016 (2016-05-01) description, specific embodiments, and figures 1-3 | 2, 4-5 |
| X | CN 102322694 A (SOUTH CHINA UNIVERSITY OF TECHNOLOGY) 18 January 2012 (2012-01-18) description, specific embodiments, and figures 1-3 | 1, 3, 6-16 |
| Y | CN 102322694 A (SOUTH CHINA UNIVERSITY OF TECHNOLOGY) 18 January 2012 (2012-01-18) description, specific embodiments, and figures 1-3 | 2, 4-5 |

☑ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 December 2022** | **16 December 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2022/125029** |

**C.     DOCUMENTS CONSIDERED TO BE RELEVANT**

| Category* | Citation of document, with indication, where appropriate, of the relevant passages | Relevant to claim No. |
| --- | --- | --- |
| X | CN 110431362 A (University of Adelaide) 08 November 2019 (2019-11-08) description, specific embodiments, and figures 1-10 | 1, 3, 6-16 |
| Y | CN 110431362 A (University of Adelaide) 08 November 2019 (2019-11-08) description, specific embodiments, and figures 1-10 | 2, 4-5 |
| Y | CN 104410329 A (CLEAN ENERGY RESEARCH INSTITUTE CO., LTD., CHINA HUANENG GROUP et al.) 11 March 2015 (2015-03-11) description, specific embodiments, and figures 1-5 | 2 |
| A | CN 105841363 A (SOUTH CHINA UNIVERSITY OF TECHNOLOGY) 10 August 2016 (2016-08-10) entire document | 1-16 |

**INTERNATIONAL SEARCH REPORT**
Information on patent family members

International application No.

**PCT/CN2022/125029**

| Patent document cited in search report | | | Publication date (day/month/year) | Patent family member(s) | | | Publication date (day/month/year) |
|---|---|---|---|---|---|---|---|
| RU | 39688 | U1 | 10 August 2004 | None | | | |
| CN | 102959344 | A | 06 March 2013 | US | 2013074829 | A1 | 28 March 2013 |
| | | | | EP | 2580537 | A1 | 17 April 2013 |
| | | | | AU | 2011264424 | A1 | 10 January 2013 |
| | | | | CA | 2801944 | A1 | 15 December 2011 |
| | | | | WO | 2011153591 | A1 | 15 December 2011 |
| | | | | CN | 102959344 | B | 11 May 2016 |
| | | | | US | 8944046 | B2 | 03 February 2015 |
| | | | | EP | 2580537 | B1 | 04 September 2019 |
| TW | 201616071 | A | 01 May 2016 | | TWI540298 | B | 01 July 2016 |
| CN | 102322694 | A | 18 January 2012 | CN | 102322694 | B | 15 May 2013 |
| CN | 110431362 | A | 08 November 2019 | EP | 3571448 | A1 | 27 November 2019 |
| | | | | WO | 2018132875 | A1 | 26 July 2018 |
| | | | | US | 2019346177 | A1 | 14 November 2019 |
| | | | | AU | 2018210678 | A1 | 22 August 2019 |
| CN | 104410329 | A | 11 March 2015 | None | | | |
| CN | 105841363 | A | 10 August 2016 | CN | 105841363 | B | 27 February 2018 |

Form PCT/ISA/210 (patent family annex) (January 2015)

**REFERENCES CITED IN THE DESCRIPTION**

**Patent documents cited in the description**

- CN 202111197764